# EUROPEAN PATENT SPECIFICATION

(11) **EP 1 008 282 B1**
(45) Date of publication and mention of the grant of the patent: **26.05.2004**
(21) Application number: 98909519.5
(22) Date of filing: 12.03.1998
(51) Int. Cl.: H05K 9/00

(54) **BOX FOR AN ELECTRICAL DEVICE**
GEHÄUSE FÜR EINE ELEKTRISCHE EINRICHTUNG
BOITIER POUR DISPOSITIF ELECTRIQUE

(30) Priority: 13.03.1997 FI 971050
(43) Date of publication of application: 14.06.2000
(73) Proprietor: Nokia Corporation, 02150 Espoo (FI)
(72) Inventor: KUIVILA, Heikki, FIN-04300 Tuusula (FI); NENONEN, Pertti, FIN-08500 Lohja as. (FI)
(74) Representative: Saijonmaa, Olli-Pekka
(86) International application number: PCT/FI1998/000220
(87) International publication number: WO 1998/041077

(56) References cited:
- EP-A- 0 696 749
- DE-A- 3 215 345
- DE-A- 4 316 763
- GB-A- 2 256 286
- US-A- 5 511 798

## Description

This invention relates to a casing of an electronic apparatus, wherein said casing has a wall which is made of an electrically conductive material, provides shielding against interference and has one or more through holes for optical cables.

Electronic apparatus such as telephone exchanges and other such communications-controlling apparatus which contain optical cables and operate at high frequencies or generate a lot of strong harmonic frequencies shall be shielded against interference so as to minimize the spreading of said electromagnetic oscillations into the surroundings of the apparatus in question. Shielding against interference is provided by making the casing of the apparatus from an electrically conductive material such as metal or metal-coated plastic. The casing of the apparatus has through holes in it for optical communications cables, which typically are made of plastic-coated fiberglass, or the cables are brought to the casing through metallic, spring-like gaskets (EMI gaskets).

Optical cables and their through holes are problematic as regards interference shielding because they break the continuity of the interference shielding interface formed by the casing so that interfering frequencies may escape outside the apparatus. Furthermore, cable path uncontrollability has been a problem with known apparatus. The cables may have been sharply bent so that leakage of light might occur in the course of time.

An object of this invention is to provide a solution for guiding an optical cable through the interference shield interface formed by the casing of an electronic apparatus, avoiding at least substantially the problems mentioned above. The invention is characterized in that a through hole in the casing constitutes a channel between the curved surfaces of parts made of an electrically conductive material and attached to each other in a detachable manner, the radius of curvature of said channel being such that full reflection of light will occur in an optical cable bent so as to correspond to the shape of the channel.

In accordance with the invention a cable through channel and the cable that follows the shape of the channel have a certain minimum radius of curvature at which light is retained wholly within the cable and will not leak outside. Naturally the radius may be greater than said minimum. The minimum radius of curvature varies depending on the cable and depending on for how long the apparatus is designed to last; a smaller radius of curvature increases the risk of light leaks occurring in the course of time. For example, the service life required of a telephone exchange may be tens of years.

The curvature of the cable through channel can also have effect on the cable path both within the casing of the apparatus and immediately outside it. A curved channel makes it possible to direct the cable such that its route between certain fixed points is substantially straight or otherwise controlled so that there will not occur indefinite bending that causes leakage of light. Furthermore, when the channel is curved, it can be longer, which is advantageous as regards the interference shielding of the casing.

Installation of cables in conjunction with the assembly of the apparatus becomes easier if the cable through channel comprises components attached to each other in a detachable manner according to the invention. An optical cable with connector parts at the end of the cable can be fitted into its place while said components are detached from each other, and the channel can be designed narrower than before since it will not be necessary to pass the wide connector part at the end of the cable through the channel. A narrower channel, into which only the necessary cables can be just fitted, is again advantageous as regards the interference shielding of the casing.

The shape of a through channel for an optical cable may be a circular arc the length of which, as defined using the central angle corresponding to the arc, is advantageously from 45° to 180°, preferably from 60° to 120°, approximately. Within these limits, the path of the cable can be arranged in the appropriate manner. The radius of curvature of the channel is preferably at least 2 to 3 cm, approximately, the latter value being sufficient for applications of which long-term operational reliability is expected.

The cable through channels in an apparatus according to the invention may advantageously comprise components attached to each other in a detachable manner so that said components confine between them a plurality of parallel channels such that one or more optical cables are fitted to each of the channels. Such a construction facilitates parallel installation of cables e.g. in a telephone exchange where tens or hundreds of cables may be connected to one and the same unit. The construction may comprise e.g. a rail-like part permanently fixed to the casing and including a series of parallel, curved grooves, and a series of cover parts detachably attached to said part, each cover part covering one or more of said grooves and by means of which the through channels formed by the grooves can be opened for the installation of cables and closed after that.

The invention will now be described in more detail with the help of illustrative examples and referring to the accompanying drawing wherein
- Fig. 1: schematically shows an electronic apparatus according to the invention with optical cables connected to it,
- Fig. 2: shows components belonging to the casing of the apparatus which confme the cable through channels, partly detached from each other for the installation of cables, and
- Fig. 3: shows in the form of section III-III of Fig. 2 said components which can be detachably attached to each other.

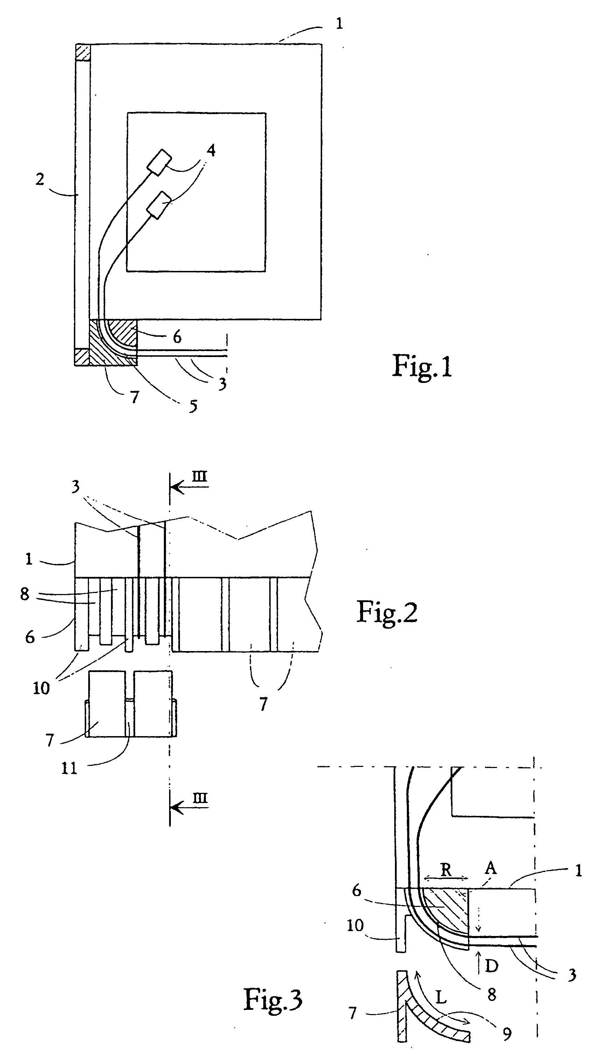

Fig. 1 shows an electronic apparatus, such as a central unit controlling communications, equipped with a metal casing 1 which serves as an interference shield. One side wall 2 of the casing 1 is made detachable so as to facilitate installation of optical cables 3. The cables 3 have a diameter of about 3 mm, for example, and at the end of each cable inside the casing 1 there is a connector part 4 the diameter of which is e.g. about 1 cm or more. For cables 3 there is on a wall of the casing 1 a through channel 5 which is shaped like a circular arc (L) and has a radius of curvature (R) of about 3 cm, corresponding to a central angle (A) of 90°, and the diameter (D) of which is narrower than the cable connector parts 4 (cf. Fig. 3). The channel 5 is confined by metal parts 6, 7 connected with the casing 1 of the apparatus and detachable from each other in order to fit the cables 3 into the curved grooves in said parts in conjunction with cable installation. This arrangement facilitates cable installation independent of the size of the connector parts 4 at the ends of the cables and of the diameter of the through channel 5. As said parts 6, 7 are attached to each other, the through channels 5 with the cables 3 in them are left between the curved surfaces of the grooves in the parts.

Figs. 2 and 3 show in more detail an application for providing the through channels 5 for cables 3. The parts confining the channels 5 comprise a rail-like part 6 connected with the casing I of the apparatus, including parallel curved grooves 8 to form the channels 5. Against that rail-like part 6 are attached parallel cover parts 7 the inner surface 9 of which (cf. Fig. 3) is curved so as to correspond to said grooves 8 and the channels 5 formed by said grooves. The cover parts 7 are detachable and attachable independent of each other and in the application depicted in the drawing each of them confines four parallel channels 5. To secure the attachment of parts 6, 7, part 6 has protruding guide pins 10 and the cover parts 7 have corresponding guide grooves 11 to receive the guide pins. The cover parts 7 are locked in place by screws (not shown).

Dimensions of the curved through channel 5 for cables 3 are based on the so-called waveguide theory according to which the attenuation of interfering frequencies increases as the length (L) of the channel increases and the relative attenuation of different frequencies depends on the size of the cross-section (D) of the channel. Thus, the cross-section of the channel can be chosen according to the peak of interfering frequencies generated by the apparatus.

It is obvious to one skilled in the art that various embodiments of the invention are not limited to the examples described above but may vary within the scope of the claims set forth below. The central angle corresponding to the arc formed by the cable through channel 5 is 90° in the drawing but it may vary according to the incoming direction of the cables and according to the location of the cable ends, i.e. connector parts 4, in the casing 1 with respect to the through channels 5. The idea is to direct the cables so as to avoid uncontrollable sharp bends that would cause leaks in them. In addition, the number of cables fitted into a single through channel 5 may vary, and optimally the channel is filled with adjacent cables so that space is not left unused, which would unnecessarily degrade the interference shielding.

## Claims

1. A casing (1) of an electronic apparatus wherein a casing wall, which is made of an electrically conductive material and provides shielding against interference, has one or more through holes (5) for optical cables (3), **characterized in that** a through hole constitutes a channel (5) between curved surfaces (8, 9) of parts (6, 7) which are made of an electrically conductive material and attached to each other in a detachable manner, the radius of curvature (R) of said channel being such that full reflection of light will occur in an optical cable (3) bent so as to correspond to the shape of the channel.

2. The casing of claim 1, **characterized in that** the casing (1) is made of metal.

3. The casing of claim 1 or 2, **characterized in that** the parts (6, 7) attached to each other that confine the through channel (5) of the cable (3) are made of metal.

4. The casing of any one of the preceding claims, **characterized in that** the shape of the through channel (5) is a circular arc which has a central angle (A) of at least about 45°.

5. The casing of claim 4, **characterized in that** the arc formed by the through channel (5) corresponds to a central angle (A) the size of which is from about 60° to about 120°.

6. The casing of any one of the preceding claims, **characterized in that** the parts (6, 7) detachably attached to each other confine between them a plurality of parallel through channels (5), one or more optical cables (3) being fitted into each of the channels.

7. The casing of any one of the preceding claims, **characterized in that** there is at that end of the optical cable (3) which is inside the casing (1) a connector part (4) wider than the cross section (D) of the through channel (5).

8. The casing of any one of the preceding claims, **characterized in that** a through channel (5) contains a plurality of parallel cables (3) inserted in the channel so that the channel is substantially free of empty space that would adversely affect the shielding against interference.

## Patentansprüche

1. Ein Gehäuse (1) einer elektronischen Vorrichtung, wobei eine Gehäusewand, welche aus einem elektrisch leitfähigen Material gemacht ist und mit einer Abschirmung gegen Interferenzen ausgestattet ist, eine oder mehrere Durchgangsbohrungen (5) für optische Kabel (3) hat, **dadurch gekennzeichnet, dass** die Durchgangsbohrungen einen Kanal (5) zwischen gekrümmten Flächen (8, 9) von Teilen (6, 7) darstellen, welche aus einem elektrisch leitfähigen Material gemacht sind und welche miteinander auf eine lösbare Weise befestigt sind, wobei der Radius der Krümmung (R) des Kanals so ausgeführt ist, dass eine volle Reflektion des Lichts in einem optischen Kabel (3) eintritt, welches so gebogen ist, dass es der Form des Kanals entspricht.

2. Das Gehäuse gemäß Anspruch 1, **dadurch gekennzeichnet, dass** das Gehäuse (1) aus Metall gemacht ist.

3. Das Gehäuse gemäß der Ansprüche 1 oder 2, **dadurch gekennzeichnet, dass** die Teile (6, 7), die miteinander befestigt sind, wodurch der Durchgangskanal (5) des Kabels (3) begrenzt ist, aus Metall gemacht sind.

4. Das Gehäuse gemäß einem der vorhergehenden Ansprüche, **dadurch gekennzeichnet, dass** die Gestalt des Durchgangskanals (5) ein Kreisbogen ist, welcher einen Zentralwinkel (A) von mindestens ca. 45° hat.

5. Das Gehäuse gemäß Anspruch 4, **dadurch gekennzeichnet, dass** der Bogen, der durch den Durchgangskanal (5) gebildet wird, einem Zentralwinkel (A) entspricht, dessen Größe ca. 60° bis ca. 120° ist.

6. Das Gehäuse gemäß einem der vorhergehenden Ansprüche, **dadurch gekennzeichnet, dass** die Teile (6, 7), die lösbar miteinander befestigt sind, zwischen sich eine Vielzahl von parallelen Durchgangskanälen (5) begrenzen, wobei eines oder mehrere optische Kabel (3) in jedem der Kanäle eingepasst sind.

7. Das Gehäuse gemäß einem der vorhergehenden Ansprüche, **dadurch gekennzeichnet, dass** an dem Ende des optischen Kabels (3), welches in dem Gehäuse (1) ist, ein Verbindungsteil (4) ist, welches breiter ist als der Querschnitt (D) des Durchgangskanals (5).

8. Das Gehäuse gemäß einem der vorhergehenden Ansprüche, **dadurch gekennzeichnet, dass** ein Durchgangskanal (5) eine Vielzahl von parallelen Kabeln (3) enthält, die in den Kanal eingesetzt sind, so dass der Kanal im Wesentlichen frei von leerem Raum ist, der nachteilig die Abschirmung gegen Interferenzen beeinflussen würde.

## Revendications

1. Boîtier (1) d'un dispositif électronique dans lequel une paroi de boîtier, qui est réalisée en un matériau électriquement conducteur et qui réalise un blindage contre les interférences, comporte un ou plusieurs trous traversants (5) pour des câbles optiques (3), **caractérisé en ce qu'**un trou traversant constitue un canal (5) entre des surfaces incurvées (8, 9) de parties (6, 7) qui sont réalisées en un matériau électriquement conducteur et fixées l'une à l'autre de manière détachable, le rayon de courbure (R) dudit canal étant tel qu'une réflexion totale de la lumière se produira dans un câble optique (3) incurvé de façon à correspondre à la forme du canal.

2. Boîtier selon la revendication 1, **caractérisé en ce que** le boîtier (1) est réalisé en métal.

3. Boîtier selon la revendication 1 ou 2, **caractérisé en ce que** les parties (6, 7) fixées l'une à l'autre qui confinent le canal traversant (5) du câble (3) sont réalisées en métal.

4. Boîtier selon l'une quelconque des revendications précédentes, **caractérisé en ce que** la forme du canal traversant (5) est un arc circulaire qui a un angle central (A) d'au moins environ 45°.

5. Boîtier selon la revendication 4, **caractérisé en ce que** l'arc formé par le canal traversant (5) correspond à un angle central (A) dont la dimension est d'environ 60° à environ 120°.

6. Boîtier selon l'une quelconque des revendications précédentes, **caractérisé en ce que** les parties (6, 7) fixées l'une à l'autre de manière détachable confinent entre elles une pluralité de canaux traversants (5) parallèles, un ou plusieurs câbles optiques (3) étant insérés dans chacun des canaux.

7. Boîtier selon l'une quelconque des revendications précédentes, **caractérisé en ce qu'**il y a, à l'extrémité du câble optique (3) qui est à l'intérieur du boîtier (1), une partie de connecteur (4) plus large que la section (D) du canal traversant (5).

8. Boîtier selon l'une quelconque des revendications précédentes, **caractérisé en ce qu'**un canal traversant (5) contient une pluralité de câbles parallèles (3) insérés dans le canal de sorte que le canal soit sensiblement exempt d'espace vide qui affecterait négativement le blindage contre les interférences.
